# FASCICULE DE BREVET EUROPEEN

(11) **EP 2 138 455 B1**
(45) Date de publication et mention de la délivrance du brevet: **09.07.2014**
(21) Numéro de dépôt: 09354023.5
(22) Date de dépôt: 04.06.2009
(51) Int. Cl.: B81C 1/00

(54) **Procédé de réalisation d'une structure MEMS comportant un élément mobile au moyen d'une couche sacrificielle hétérogène**
Verfahren zum Herstellen einer MEMS-Struktur mit einem beweglichen Element durch die Anwendung einer heterogenen Opferschicht
Process for making a MEMS structure with a moving element using a heterogeneous sacrificial layer

(30) Priorité: 23.06.2008 FR 0803503
(43) Date de publication de la demande: 30.12.2009
(73) Titulaire: Commissariat à l'Énergie Atomique et aux Énergies Alternatives, 75015 Paris (FR)
(72) Inventeur: Charvet, Pierre-Louis, 38950 Saint-Martin-le-Vinoux (FR)
(74) Mandataire: Hecké, Gérard

(56) Documents cités:
- US-A1- 2007 138 582

## Description

### Domaine technique de I'invention

L'invention est relative à un procédé de réalisation, sur un substrat, d'une structure comportant au moins un élément mobile présentant une zone libre solidaire du substrat par une zone d'accroche, la structure mobile étant constituée par au moins une couche active, le procédé comporte successivement le dépôt et la structuration d'un premier matériau sacrificiel pour former un premier motif en premier matériau sacrificiel, le dépôt de la couche active et sa structuration pour permettre l'accès au premier matériau sacrificiel, l'élimination du premier matériau sacrificiel, libérant la zone libre de la couche active.

### État de la technique

Beaucoup de micro-systèmes électromécaniques intégrés (« MEMS : micro electro-mechanical systems »), comportent des micro-structures suspendues planes. C'est par exemple le cas d'actionneurs, de capteurs, de commutateurs, de condensateurs variables, d'inductances (self) ou de résonateurs à onde acoustique de volume suspendus. En micro-technologie ou microélectronique, les micro-structures suspendues sont réalisées par l'utilisation d'une couche sacrificielle. Les étapes classiques d'obtention d'une micro-structure suspendue sont décrites dans la demande de brevet US 10/536,890 et sont représentées, sous forme simplifiée, aux figures 1 à 5.

Dans une première étape représentée à la figure 1, une couche 2 en matériau sacrificiel est déposée sur un substrat 1. La couche 2 est typiquement en matériau polymère, en oxyde de silicium ou en tungstène. La deuxième étape, représentée à la figure 2, consiste à lithographier et à graver la couche 2 de manière à former un motif 2a en matériau sacrificiel, le motif recouvrant une partie du substrat 1 sur laquelle doit être formée la structure suspendue. Ensuite, dans une troisième étape représentée à la figure 3, une couche 3 active qui forme la structure suspendue est déposée sur le substrat 1 et sur le motif 2a en matériau sacrificiel. La couche 3 active peut être conductrice ou diélectrique ou constituée par un empilement de plusieurs couches différentes. La quatrième étape, représentée à la figure 4, consiste à lithographier et graver la couche 3 active jusqu'au niveau de la face avant de la couche sacrificielle 2, de manière à délimiter la structure suspendue 5 par des ouvertures 4 dans la couche 3 active. Dans une cinquième étape, représentée à la figure 5, la couche sacrificielle est retirée par gravure sèche ou gravure humide, de manière à constituer un espace libre entre le substrat et la structure suspendue 5, libérant ainsi la structure suspendue.

Le matériau sacrificiel constituant le motif 2a est choisi de manière à ce que sa gravure soit sélective par rapport au matériau de réalisation de la micro-structure. Par exemple, la couche sacrificielle 2 peut être en oxyde de silicium (SiO₂) et la structure suspendue peut être en polysilicium. Une deuxième combinaison comporte une couche sacrificielle en matériau polymère et une structure suspendue en SiO₂. Une troisième possibilité consiste à utiliser une couche sacrificielle en matériau polymère et une structure suspendue en métal. L'utilisation d'une couche sacrificielle qui se retire par gravure humide, par exemple SiO₂ dans un bain chimique à base d'acide fluorhydrique (HF), pose des problèmes de collage des structures lors de l'étape de libération. On remarque aisément que la réalisation d'un dispositif est principalement liée aux choix des matériaux qui le composent et aux problématiques qui ont trait à leur dépôt et surtout à leur retrait sélectif.

De manière conventionnelle, les microsystèmes ne sont pas constitués par un seul matériau, mais par une pluralité de matériaux qui ont des rôles bien précis et qui sont choisis en fonction de leurs spécificités chimiques, mécaniques ou électriques. Il en résulte que le retrait sélectif de la couche sacrificielle doit se faire au moyen d'un procédé de gravure qui doit être sélectif vis-à-vis de tous les matériaux en contact avec la couche sacrificielle ou qui présentent une surface libre, ce qui limite fortement les possibilités de conception. Certaines architectures deviennent alors irréalisables à cause de la complexité de leurs procédés de réalisation.

Un procédé de réalisation sur substrat d'une structure comportant au moins un élément mobile, le procédé comportant successivement le dépôt et la structuration de deux matériaux sacrificiels différents, est connu du document US 2007/0138582 A1.

### Objet de l'invention

L'invention a pour objet le relâchement des contraintes qui pèsent sur les étapes de réalisation d'un dispositif comportant une structure mobile libérée par l'élimination d'un matériau sacrificiel.

Le procédé selon l'invention est caractérisé par les revendications annexées et plus particulièrement par le fait qu'il comporte avant le dépôt du premier matériau sacrificiel, le dépôt d'un second matériau sacrificiel et après formation du premier motif, la formation d'un second motif dans le second matériau sacrificiel, de manière à ce que le premier motif en premier matériau sacrificiel étant disposé sur le second motif en un second matériau sacrificiel, le premier motif laisse libre une zone de largeur prédéfinie à la périphérie d'une face supérieure du second motif, la couche active recouvrant au moins l'ensemble des parois latérales des premier et second motifs et ladite zone de largeur prédéfinie du second motif, et en ce qu'il comporte l'élimination du second matériau sacrificiel après l'élimination du premier matériau sacrificiel.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

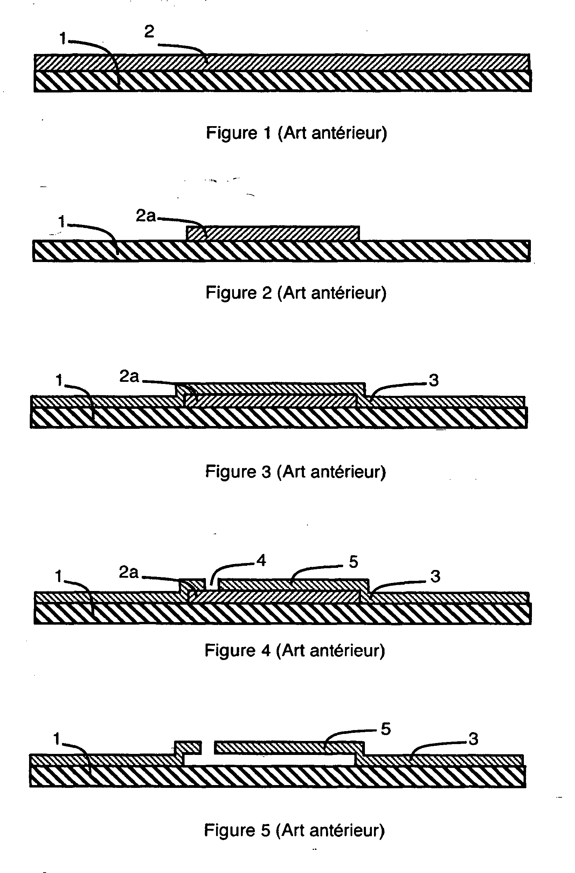

- les figures 1 à 5 représentent, de manière schématique, en coupe, les principales étapes de réalisation d'une structure suspendue comportant une zone libre obtenue dans un mode de réalisation particulier du procédé selon l'art antérieur,

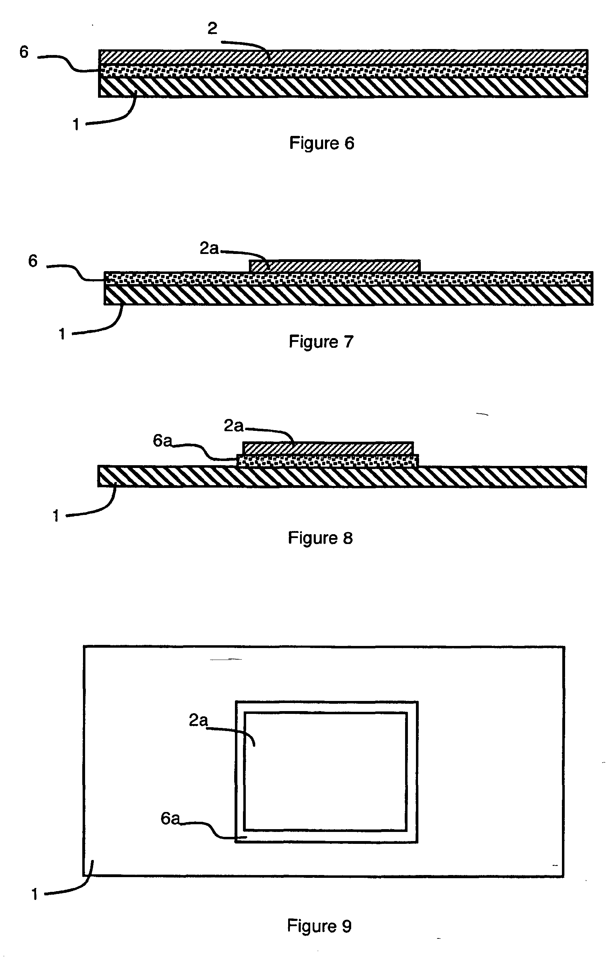

- les figures 6 à 8, 10, 11, 13 et 14 représentent, de manière schématique, en coupe, les principales étapes de réalisation d'une structure suspendue comportant une zone libre obtenue dans un mode de réalisation particulier du procédé selon l'invention,

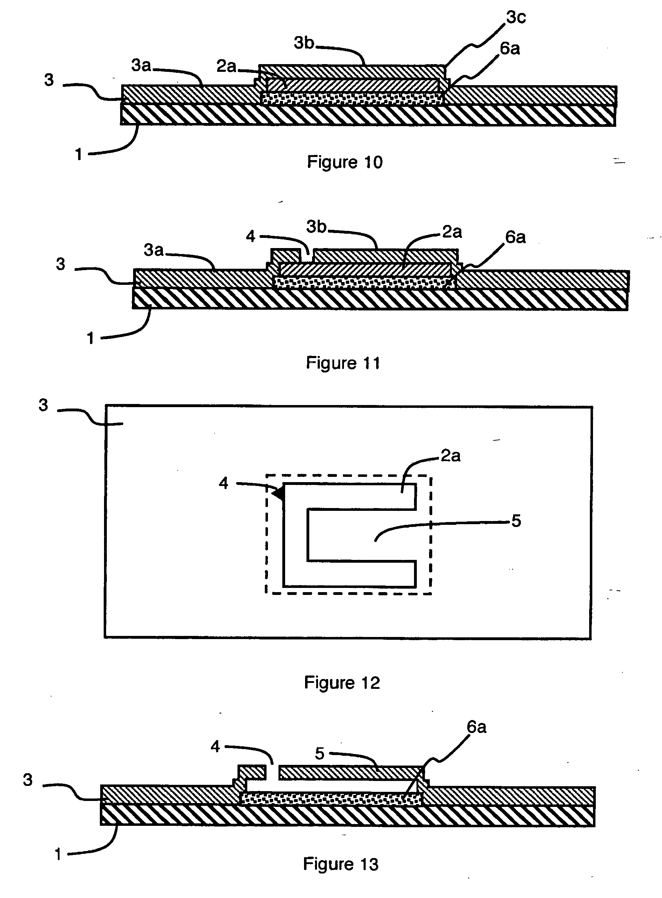

- les figures 9 et 12 représentent, de manière schématique, en vue de dessus, les étapes du procédé illustrées respectivement par les figures 8 et 11,

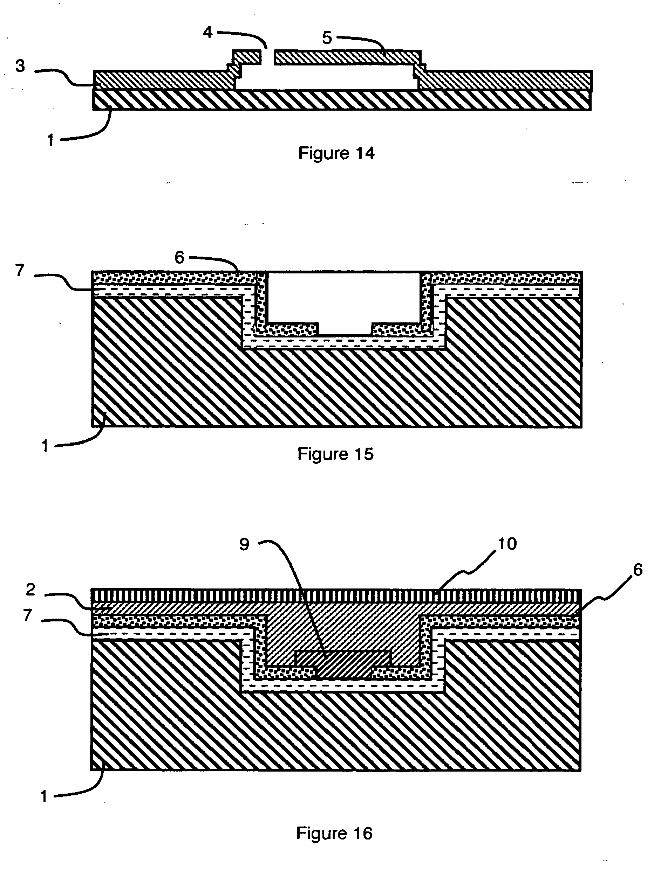

- la figures 15 à 20 représentent, de manière schématique, en coupe, une variante de réalisation d'une structure suspendue comportant une zone libre obtenue par le procédé selon l'invention.

### Description d'un mode préférentiel de l'invention

Comme illustré aux figures 6 et 7, des premier et second matériaux sacrificiels 2 et 6 sont déposés sur un substrat 1. Le second matériau sacrificiel 6 est disposé entre le substrat 1 et le premier matériau sacrificiel 2. La couche en premier matériau sacrificiel 2 est structurée de manière classique, par exemple par photolithographie et gravure, de manière à former un premier motif sacrificiel 2a prédéterminé. La gravure du premier matériau sacrificiel est réalisée sélectivement par rapport à la couche en second matériau sacrificiel 6. La face supérieure de la couche 2 est sensiblement parallèle à la surface du substrat 1. Les couches en premier et second matériaux sacrificiels 2 et 6 sont structurées par des chimies de gravures différentes.

Comme illustré à la figure 8, le second matériau sacrificiel 6 est ensuite structuré sélectivement par rapport au premier matériau sacrificiel 2 et au substrat 1 pour former un second motif sacrificiel 6a en second matériau sacrificiel. Le second motif sacrificiel 6a est légèrement plus grand que le premier motif sacrificiel 2a en premier matériau sacrificiel. Il est possible de réaliser la gravure du second matériau sacrificiel au moyen de nouvelles étapes de photolithographies et gravures. A ce stade de la réalisation, les premier et second matériaux sacrificiels 2 et 6 ont été structurés pour former respectivement des premier et second motifs sacrificiels 2a et 6a sur le substrat 1. Le premier motif 2a laisse libre une zone de largeur prédéfinie sur la surface supérieure du second motif 6a, à la périphérie du second motif. Ainsi, dans une vue de dessus illustrée à la figure 9, les couches sacrificielles 2 et 6 et le substrat 1 sont visibles et le second motif sacrificiel 6a est visible de manière continue autour du premier motif sacrificiel 2a.

De manière avantageuse, la différence de dimension entre deux motifs consécutifs en matériaux sacrificiels, ici 2a et 6a, est liée aux applications visées. Cette différence de dimension correspond à une largeur et une longueur de garde nécessaire au non débordement d'un agent de gravure sur les parois latérales du motif sacrificiel inférieur. Ainsi, pour la réalisation d'une structure mobile telle qu'une poutre ou une membrane micromécanique, cette distance de garde est de l'ordre de quelques micromètres. Pour une poutre ou une membrane nanométrique, cette distance est de l'ordre de quelques nanomètres. La distance de garde dépend également de l'épaisseur des motifs inférieurs, ici 6a, de la durée d'attaque et des agents d'attaques utilisés.

Le nombre de couches sacrificielles utilisées dans la réalisation d'une structure, par exemple micromécanique ou microélectronique, comportant une zone libre, dépend de la complexité de la structure à réaliser. Les couches sacrificielles permettent la structuration des différents éléments constitutifs de la structure (électrodes, cavités d'air, intraconnexion, résistances, couches isolantes ...). Chaque couche sacrificielle peut permettre ainsi la structuration de tout ou partie d'au moins un élément de la structure à former.

D'une manière générale, dans le cas d'un empilement sacrificiel de plusieurs couches en matériaux sacrificiels, les matériaux qui constituent l'empilement sacrificiel sont choisis afin que la couche supérieure de l'empilement, le motif sacrificiel supérieur, puisse être éliminée sélectivement par rapport à la couche immédiatement inférieure. Par ailleurs, une couche de l'empilement occupe une surface légèrement inférieure à la couche sacrificielle sur laquelle elle est déposée et laisse libre une zone de largeur prédéfinie de la surface supérieure de la couche sacrificielle immédiatement inférieure, en périphérie de cette dernière comme cela est illustré à la figure 9 avec les motifs 2a et 6a.

Ainsi, l'utilisation de couches sacrificielles superposées permet de relâcher les contraintes liées au choix des matériaux de l'empilement technologique de la structure réalisée. Un plus grand choix de matériaux est donc possible et chaque matériau peut être utilisé plusieurs fois dans l'empilement. De plus, ce procédé peut être utilisé dans tous les cas de figure que le substrat soit électriquement conducteur ou non.

Comme illustré aux figures 10 et 11, une couche 3 active est ensuite déposée, pleine plaque, sur le substrat 1 et recouvre les premier et second motifs sacrificiels 2a et 6a. La couche 3 active comporte alors une partie déposée directement sur le substrat 1 et une partie déposée sur les matéraiux 6 et 2. La couche 3 recouvre l'intégralité de la surface externe du motif sacrificiel supérieur de l'empilement des matériaux sacrificiels. Ici, la couche 3 active recouvre la surface supérieure du premier motif 2a et ses parois latérales. La couche active recouvre également la surface supérieure laissée libre du second motif 6a et ses parois latérales.

Si un matériau sacrificiel additionnel est utilisé, ce dernier est déposé au-dessus du premier matériau sacrificiel 2 pour former un motif sacrificiel au dessus du motif 2a. Dans ce cas, la surface supérieure et les parois latérales du motif sacrificiel sont recouvertes par la couche active et seulement une portion périphérique et les parois principales du premier motif 2a sont recouvertes. D'une manière générale, la couche 3 active recouvre la surface supérieure de la couche sacrificielle qui forme le sommet de la pyramide en matériaux sacrificiels. Par ailleurs, la couche 3 active recouvre également la surface périphérique supérieure de toutes les couches sacrificielles inférieures ainsi que leurs parois latérales.

La couche active 3 est, lors de son dépôt, en contact direct avec toutes les couches sacrificielles et le substrat 1. Il en résulte que le premier motif 2a en premier matériau sacrificiel est en contact direct avec le second motif 6a en second matériau sacrificiel par l'intermédiaire de sa surface inférieure et en contact direct avec la couche 3 active par l'intermédiaire des autres surfaces. De manière analogue, le second motif 6a en second matériau sacrificiel est en contact direct avec le premier matériau sacrificiel 2 par l'intermédiaire de sa surface supérieure. Il est également en contact direct avec la couche active 3 par l'intermédiaire de la périphérie de sa surface supérieure et par ses parois latérales. Le second motif 6a est également en contact direct avec le substrat 1 par l'intermédiaire de sa surface inférieure.

De manière schématique, la couche active 3 comporte trois zones. La première zone 3a est disposée directement sur le substrat 1 et est horizontale sur la figure 9. La seconde zone 3b est disposée sur le premier matériau sacrificiel 2, c'est-à-dire sur la couche sacrificielle supérieure de l'empilement, et est également horizontale sur la figure 9. Avantageusement, les zones 3a et 3b sont parallèles. La troisième zone 3c relie les première et seconde zones 3a et 3b de la couche active et est oblique sur les figures 10 et 11.

Une ouverture 4 est réalisée dans la couche active 3, uniquement dans la seconde zone 3b, afin de ne permettre l'accès qu'au premier motif 2a en premier matériau sacrificiel 2. L'ouverture 4 est réalisée de manière classique, par exemple, par photolithographie et gravure. De cette manière, l'accès au premier matériau sacrificiel 2 est possible pour permettre son élimination.

L'ouverture 4 a plusieurs fonctions, elle permet principalement de donner accès à la couche sacrificielle à éliminer, mais elle peut également permettre la définition au moins d'une partie d'un motif de la couche active 3. Comme illustré à la figure 12, l'ouverture 4 est formé dans la zone 3b de la couche 4 et permet simultanément l'accès au premier matériau sacrificiel 2 et la définition du futur élément mobile 5 de la structure. L'ouverture 4 est formée au-dessus du second motif sacrificiel qui est représenté en trait pointillé sur la figure 12.

Comme illustré aux figures 13 et 14, le premier matériau sacrificiel 2 étant accessible, il est éliminé sélectivement par rapport aux autres matériaux présents. Comme précisé précédemment, le premier matériau sacrificiel n'étant en contact direct qu'avec le second matériau sacrificiel 6 et la couche active 3, le procédé de gravure ne doit être sélectif que par rapport à ces matériaux (figure 13). Une fois le premier matériau sacrificiel éliminé, la seconde zone 3b de la couche active 3 n'est plus supportée par l'empilement des motifs en premier et second matériaux sacrificiels 2a et 6a. Il existe maintenant, un volume vide qui a les dimensions du premier motif 2a. Ce volume vide est délimité par le second motif et par la couche active et ne communique avec l'extérieure que par l'ouverture 4.

La couche active 3 forme alors au moins une partie de la structure qui comporte un élément mobile 5. Cet élément mobile comporte une zone libre, c'est-à-dire une structure suspendue, uniquement solidaire du substrat par une zone d'accroche fixée sur le substrat. La zone libre est formée dans la seconde zone 3b de la couche 3. L'élément mobile 5 de la couche active 3 est disposée au-dessus et à distance du substrat 1 et est située entre l'ouverture 4 et la zone d'accroche. La zone d'accroche est constituée par les première 3a et troisième 3c zones en couche active.

Le second matériau sacrificiel 6 étant accessible, le second motif 6a est éliminé au moyen d'un procédé qui doit uniquement être sélectif par rapport au substrat 1 et à la couche active 3. Une méthode analogue est utilisée pour graver sélectivement les différents matériaux qui peuvent constituer l'empilement de couches sacrificielles additionnelles.

Les motifs en matériaux sacrificiels 2 et 6 forment, en coupe, une structure pyramidale, il en résulte que la zone vide, délimitée par la couche active, occupe le même volume qui a également la forme d'une pyramide.

L'utilisation d'un procédé comportant au moins deux matériaux sacrificiels 2 et 6 permet non seulement de cumuler les avantages de chacune des couches prises individuellement, mais également d'annuler mutuellement les inconvénients de ces dernières, typiquement la compatibilité des matériaux dans le procédé de réalisation. En effet, de cette manière, il est possible de graver sélectivement un premier motif sacrificiel 2a qui peut être identique à celui qui compose le substrat ou alors d'utiliser un agent de dégradation qui grave également le substrat ou des éléments qui sont recouverts par le second motif sacrificiel 6a.

De manière à permettre l'obtention de procédés de gravure sélectifs, les éléments qui rentrent en jeu dans la formation d'un dispositif comportant une structure mobile sont généralement constitués par des éléments chimiques différents.

Classiquement, les matériaux sacrificiels 2 et 6 sont constitués par des matériaux différents qui sont également différents des matériaux qui constituent la couche active 3. Cependant, il est également possible que les matériaux sacrificiels 2 et 6 présentent les mêmes constituants de base.

Si les matériaux sacrificiels 2 et 6 sont réalisés dans des matériaux différents, ils peuvent être, par exemple, en oxyde de silicium, en nitrure de silicium, en silicium sous forme polycristalline ou amorphe, en matériau métallique, par exemple en molybdène. Si les matériaux sacrificiels 2 et 6 sont réalisés avec les mêmes constituants de base, les matériaux sacrificiels 2 et 6 sont formés, par exemple, respectivement en oxyde de silicium obtenu par oxydation thermique et par dépôt chimique en phase vapeur assisté par plasma. Les matériaux sacrificiels 2 et 6 peuvent également être en silicium intrinsèque et dopé ou en alliage de silicium-germanium.

Typiquement, la couche active 3 est en matériau métallique, par exemple, en chrome, en or ou un empilement de matériaux métalliques. Cependant, la couche active 3 peut également être en matériaux diélectriques. Si un actionnement électrostatique de la couche active est recherché, cette dernière comporte au moins une couche en matériau métallique.

A titre d'exemple, le procédé de réalisation est alors particulièrement avantageux avec un premier matériau sacrificiel 2 en oxyde de silicium déposé par dépôt chimique en phase vapeur assisté par plasma. Cette catégorie d'oxyde de silicium présente une vitesse de gravure qui est plus élevée que l'oxyde de silicium formé thermiquement lors d'une attaque par de l'acide fluorhydrique. L'épaisseur du premier matériau sacrificiel 2 est typiquement de l'ordre de quelques microns. Le second matériau sacrificiel 6 est par exemple du molybdène qui a une épaisseur de l'ordre de 500nm. La couche active est, par exemple, en chrome, en or, en nitrure de silicium ou un empilement de ces derniers. Utiliser d'un oxyde de silicium comme premier matériau sacrificiel 2 est particulièrement avantageux car il permet une mise en forme aisée au moyen de nombreux procédés de gravure ou de polissage. Cependant, l'oxyde de silicium est également utilisé comme diélectrique dans les circuits intégrés ce qui limite son utilisation dans le cas d'une co-intégration.

Ainsi, selon le mode particulier de réalisation illustré aux figures 6 à 12, si le substrat comporte à sa surface un oxyde de silicium ou un matériau qui ne présente pas de sélectivité de gravure par rapport à l'oxyde de silicium, un composant de type microsystème (par exemple un accéléromètre, un capteur de pression, un résonateur, une capacité variable, un micro-commutateurs...) est réalisé au moyen d'une couche sacrificielle qui est au moins partiellement en oxyde de silicium. La couche sacrificielle est alors hétérogène, c'est-à-dire composée d'au moins deux matériaux qui présentent des sélectivités de gravure entre eux.

Dans un mode de réalisation privilégié, une couche de protection 7 est formée à la surface du substrat 1. Ce mode de réalisation est particulièrement avantageux si le substrat 1 est en silicium ou dans un autre matériau électriquement conducteur. Une couche de protection en matériau diélectrique est alors formée avant l'intégration du dispositif, par exemple de type MEMS qui est alimenté par un courant électrique. A titre d'exemple, le diélectrique formé est un oxyde, typiquement un oxyde de silicium formé thermiquement.

Une variante de réalisation est illustrée aux figures 15 à 20. Cette variante de réalisation utilise une couche de protection, typiquement un oxyde de silicium formé thermiquement sur un substrat en silicium (figure 15). Dans ce mode de réalisation, une dépression 8 est formée dans le substrat 1 de silicium avant la formation de la couche de protection 7. La dépression est un trou qui peut être, par exemple, de forme carrée, rectangulaire ou circulaire.

Comme le substrat 1 comporte à sa surface un oxyde de silicium, les différents procédés de gravure utilisés pour former la structure doivent être sélectif par rapport à cet oxyde de silicium.

Comme illustré à la figure 15, le second matériau sacrificiel 6 est déposé sur la couche de protection 7 et est structuré de manière à laisser libre une surface prédéterminée de la couche de protection 7 dans le fond de la dépression 8.

Un matériau métallique est ensuite déposé et structuré afin de former un motif 9 en matériau métallique au fond de la dépression 8. Ce motif 9 en matériau métallique recouvre toute la surface libre de la couche de protection 7 et déborde également sur une portion du second matériau sacrificiel 6. Ce motif métallique 9 est typiquement une électrode d'actionnement et/ou de mesure de la structure à former.

Le matériau métallique utilisé peut être une couche de chrome, d'or, un empilement de ces derniers ou tout autre matériau adapté.

Comme illustré à la figure 16, le premier matériau sacrificiel 2 et un matériau sacrificiel additionnel 10 sont déposés et recouvrent la surface du substrat. De manière conventionnelle, une étape d'aplanissement, par exemple, par polissage mécano-chimique est réalisée entre le dépôt du premier matériau sacrificiel 2 et le dépôt du matériau sacrificiel additionnel 10.

Les couches sacrificielles utilisées présentent toutes une sélectivité de gravure au moins vis-à-vis de la couche immédiatement inférieure. Le premier matériau sacrificiel 2 et la couche de protection 7 sont sensibles aux mêmes agents de dégradation. A titre d'exemple, le premier matériau sacrificiel 2 et la couche de protection 7 sont réalisés avec le même matériau, car ils sont séparés par le second matériau sacrificiel 6.

A titre d'exemple, le premier matériau sacrificiel 2 et la couche de protection 7 sont en oxyde de silicium formé respectivement par dépôt chimique en phase vapeur assisté par plasma et par oxydation thermique. Il en résulte que ces deux matériaux 2 et 6 peuvent être dégradés par une solution d'acide fluorhydrique, par un plasma de CHF₃ ou par un plasma de CHFO₃.

De manière analogue, le second matériau sacrificiel 6 et le matériau sacrificiel additionnel 7 sont également dans le même matériau, par exemple du molybdène.

Ainsi, l'empilement des matériaux sacrificiels 2, 6 et 10 forme une alternance entre l'oxyde de silicium et le molybdène dans une direction perpendiculaire à la surface du substrat.

Avantageusement, si plusieurs matériaux sacrificiels additionnels sont utilisés, ces matériaux prolongent cette alternance de couches déposées en molybdène et oxyde de silicium.

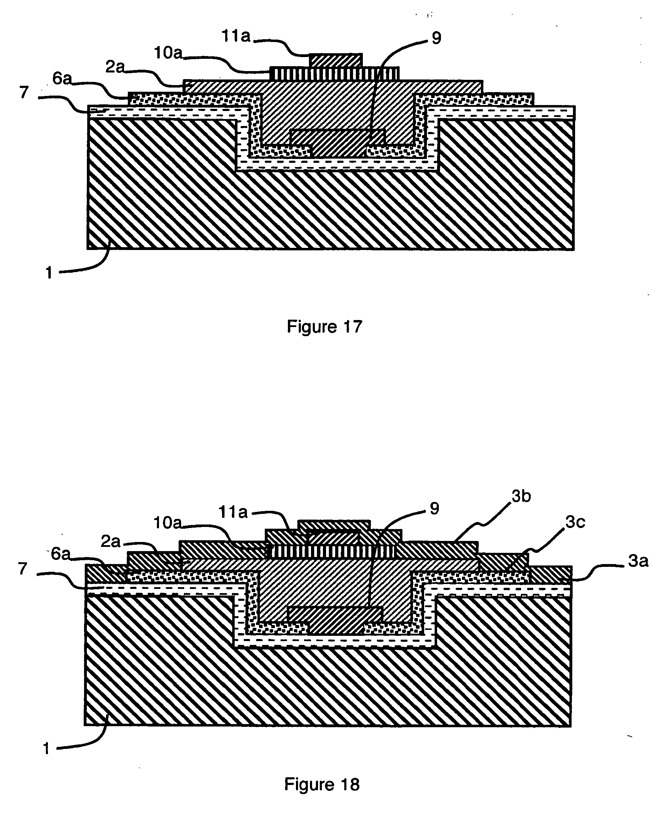

Comme illustré à la figure 17, un second matériau métallique 11 est déposé sur la couche sacrificielle additionnelle 10 et structuré de manière à former un second motif métallique 11a. La couche sacrificielle additionnelle 10, le premier matériau diélectrique 2 puis le second matériau diélectrique 6 sont structurés, par exemple, par photolithographie et gravure pour former respectivement le motif sacrificiel additionnel 10a, le premier motif sacrificiel 2a et le second motif sacrificiel 6a. Le second matériau métallique est par exemple du titane.

Ces trois motifs sacrificiels sont formés les uns sur les autre et représentent une pyramide. Comme dans le mode de réalisation précédent, chacune des couches sacrificielles est gravée indépendamment de manière à former un motif sacrificiel qui laisse apparaître, en vue de dessus, une partie du pourtour du motif sacrificiel immédiatement inférieur. Chaque motif laisse libre une zone de largeur prédéfinie à la périphérie d'une face supérieure du motif immédiatement inférieur.

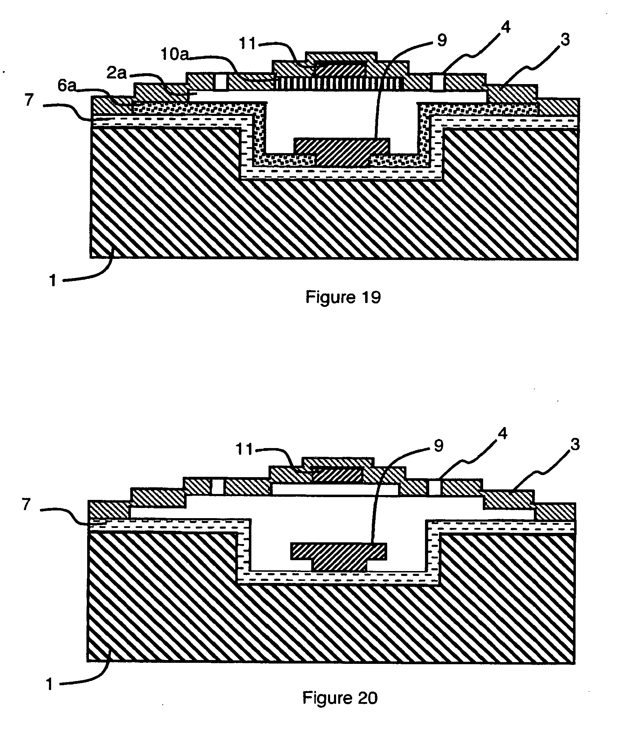

Comme illustré à la figure 18, la couche active 3 est formée et recouvre la couche de protection 7, les premier et second motifs sacrificiels 2a et 6a, le motif sacrificiel additionnel 10a et le second motif métallique 11 a. Cette couche 3 active est ensuite structurée pour former au moins une ouverture 4 qui permet l'accès à au moins un des matériaux sacrificiels, comme illustré à la figure 19. La couche active 3 est par exemple en nitrure de silicium

Une fois l'ouverture 4 formée, le premier matériau sacrificiel 2 est accessible, il est éliminé par un agent de dégradation qui permet une gravure sélective pas rapport au second matériau sacrificiel 6 et au matériau sacrificiel additionnel 10, figure 19

Comme illustré à la figure 20, après élimination de premier matériau sacrificiel 2, les matériaux sacrificiels restant peuvent être éliminés sélectivement ou simultanément selon les constituants et les chimies de gravure utilisés.
Dans ce mode de réalisation, un élément de la structure à réaliser, ici une électrode, est formé entre le dépôt du second matériau sacrificiel 6 et le dépôt du premier matériau sacrificiel 2, c'est-à-dire entre le dépôt de deux matériaux sacrificiels consécutifs. Cependant, il est également possible de former un élément de la structure entre le dépôt du premier matériau sacrificiel 2 et le matériau sacrificiel additionnel 10. De plus, cet élément peut être, par exemple, une résistance, une interconnexion ou un élément isolant.

Dans ce mode de réalisation, le second matériau métallique est par exemple du titane qui peut être gravé au moyen d'acide fluorhydrique en phase vapeur. Ce mode de réalisation est particulièrement avantageux dans le cas où le premier matériau sacrificiel est en oxyde de silicium et le second matériau métallique est en titane. En effet, ces deux matériaux peuvent être gravées au moyen d'acide fluorhydrique en phase vapeur. Le motif sacrificiel additionnel et le second motif sacrificiel sont en molybdène qui n'est pas sensible à l'acide fluorhydrique.

## Revendications

1. Procédé de réalisation, sur un substrat, d'une structure comportant au moins un élément mobile comportant une zone libre solidaire du substrat par une zone d'accroche, la structure mobile étant constituée par au moins une couche active, le procédé comporte successivement le dépôt et la structuration d'un premier matériau sacrificiel pour former un premier motif en premier matériau sacrificiel, le dépôt de la couche active et sa structuration pour permettre l'accès au premier matériau sacrificiel, l'élimination du premier matériau sacrificiel, libérant la zone libre de la couche active, le dépôt d'un second matériau sacrificiel avant le dépôt du premier matériau sacrificiel, et l'élimination du second matériau sacrificiel après l'élimination du premier matériaux sacrificiel, procédé **caractérisé en ce qu'**il comporte après la formation du premier motif, la formation d'un second motif dans le second matériau sacrificiel, de manière à ce que le premier motif en premier matériau sacrificiel étant disposé sur le second motif en un second matériau sacrificiel, le premier motif laisse libre une zone de largeur prédéfinie à la périphérie d'une face supérieure du second motif, la couche active recouvrant au moins l'ensemble des parois latérales des premier et second motifs et ladite zone prédéfinie du second motif.

2. Procédé selon la revendication 1, **caractérisé en ce qu'**il comporte la réalisation d'au moins un motif sacrificiel additionnel au-dessus du premier motif par dépôt et structuration d'au moins une couche sacrificielle additionnelle au-dessus du premier motif, chaque motif additionnel laissant libre une zone de largeur prédéfinie sur la périphérie d'une face supérieure d'un motif immédiatement inférieur.

3. Procédé selon l'une des revendications 1 et 2, **caractérisé en ce qu'**il comporte la réalisation d'un élément de ladite structure entre le dépôt de deux couches sacrificielles consécutives.

4. Procédé selon la revendication 3, **caractérisé en ce que** l'élément de ladite structure est choisi parmi une électrode, une résistance, une interconnexion, un élément isolant.

5. Procédé selon l'une quelconque des revendications 1 à 4, **caractérisé en ce que** le substrat (1) étant recouvert par une couche de protection (7), la couche de protection (7) et le premier matériau sacrificiel (2) ont les mêmes constituants principaux.

6. Procédé selon la revendication 5, **caractérisé en ce que** la couche de protection (7) est en oxyde de silicium formé thermiquement et que le premier matériau sacrificiel (2) est en oxyde de silicium réalisé par dépôt chimique en phase vapeur assisté par plasma.

7. Procédé selon l'une quelconque des revendications 5 et 6, **caractérisé en ce que** le substrat et la couche de protection sont sensibles aux mêmes agents de dégradation.

8. Procédé selon la revendication 7, **caractérisé en ce que** la couche de protection et le premier matériau sacrificiel (2) sont dégradés par une solution d'acide fluorhydrique, par un plasma de CHF3 ou par un plasma de CHF3O2.

9. Procédé selon l'une quelconque des revendications 1 à 8, **caractérisé en ce que** le premier matériau sacrificiel (2) est en SiO₂ et le second matériau sacrificiel (6) est en molybdène.

10. Procédé selon l'une quelconque des revendications 2 à 9, **caractérisé en ce que** le premier motif sacrificiel (2a) est en oxyde de silicium et le motif sacrificiel additionnel (10a) est en molybdène, le premier motif sacrificiel (2a) étant immédiatement inférieur au motif sacrificiel additionnel (10a).

11. Procédé selon l'une quelconque des revendications 2 à 10, **caractérisé en ce que** les matériaux sacrificiels (2, 6, 10) forment perpendiculairement à la surface du substrat (1) une alternance de motifs (2a, 6a, 10a) en molybdène et en oxyde de silicium.

## Patentansprüche

1. Verfahren zur Herstellung, auf einem Substrat, einer Struktur mit wenigstens einem beweglichen Element, das einen mit dem Substrat durch einen Haftbereich fest verbundenen freien Bereich umfasst, wobei die bewegliche Struktur durch wenigstens eine aktive Schicht gebildet ist, das Verfahren umfasst nacheinander das Abscheiden und das Strukturieren eines ersten Opfermaterials, um ein erstes Muster aus erstem Opfermaterial auszubilden, das Abscheiden der aktiven Schicht und deren Strukturieren, um den Zugang zu dem ersten Opfermaterial zu ermöglichen, das Entfernen des ersten Opfermaterials, wodurch der freie Bereich von der aktiven Schicht gelöst wird, das Abscheiden eines zweiten Opfermaterials vor dem Abscheiden des ersten Opfermaterials und das Entfernen des zweiten Opfermaterials nach dem Entfernen des ersten Opfermaterials, Verfahren, welches **dadurch gekennzeichnet ist, dass** es nach dem Ausbilden des ersten Musters das Ausbilden eines zweiten Musters in dem zweiten Opfermaterial umfasst, derart, dass - da das erste Muster aus erstem Opfermaterial auf dem zweiten Muster aus einem zweiten Opfermaterial angeordnet ist - das erste Muster einen Bereich mit vordefinierter Breite am Umfang einer Oberseite des zweiten Musters frei lässt, wobei die aktive Schicht wenigstens alle Seitenwände des ersten und des zweiten Musters sowie den vordefinierten Bereich des zweiten Musters überzieht.

2. Verfahren nach Anspruch 1, **dadurch gekennzeichnet, dass** es das Ausbilden wenigstens eines zusätzlichen Opfermusters oberhalb des ersten Musters durch Abscheiden und Strukturieren wenigstens einer zusätzlichen Opferschicht oberhalb des ersten Musters umfasst, wobei jedes zusätzliche Muster einen Bereich mit vordefinierter Breite am Umfang einer Oberseite eines unmittelbar darunter liegenden Musters frei lässt.

3. Verfahren nach einem der Ansprüche 1 und 2, **dadurch gekennzeichnet, dass** es das Ausbilden eines Elements der Struktur zwischen dem Abscheiden von zwei aufeinanderfolgenden Opferschichten umfasst.

4. Verfahren nach Anspruch 3, **dadurch gekennzeichnet, dass** das Element der Struktur aus einer Elektrode, einem Widerstand, einer Verbindung, einem Isolierelement ausgewählt ist.

5. Verfahren nach einem der Ansprüche 1 bis 4, **dadurch gekennzeichnet, dass**, wenn das Substrat (1) mit einer Schutzschicht (7) überzogen ist, die Schutzschicht (7) und das erste Opfermaterial (2) die gleichen Hauptbestandteile haben.

6. Verfahren nach Anspruch 5, **dadurch gekennzeichnet, dass** die Schutzschicht (7) aus thermisch gebildetem Siliziumoxid besteht und dass das erste Opfermaterial (2) aus durch plasmaunterstützte chemische Gasphasenabscheidung hergestelltem Siliziumoxid besteht.

7. Verfahren nach einem der Ansprüche 5 und 6, **dadurch gekennzeichnet, dass** das Substrat und die Schutzschicht gegenüber den gleichen Abbaumitteln empfindlich sind.

8. Verfahren nach Anspruch 7, **dadurch gekennzeichnet, dass** die Schutzschicht und das erste Opfermaterial (2) durch eine Flusssäure-Lösung, durch ein CHF3-Plasma oder durch ein CHF302-Plasma abgebaut werden.

9. Verfahren nach einem der Ansprüche 1 bis 8, **dadurch gekennzeichnet, dass** das erste Opfermaterial (2) aus SiO₂ besteht und das zweite Opfermaterial (6) aus Molybdän besteht.

10. Verfahren nach einem der Ansprüche 2 bis 9, **dadurch gekennzeichnet, dass** das erste Opfermuster (2a) aus Siliziumoxid besteht und das zusätzliche Opfermuster (10a) aus Molybdän besteht, wobei das erste Opfermuster (2a) unmittelbar unterhalb des zusätzlichen Opfermusters (10a) gelegen ist.

11. Verfahren nach einem der Ansprüche 2 bis 10, **dadurch gekennzeichnet, dass** die Opfermaterialien (2, 6, 10) senkrecht zu der Oberfläche des Substrats (1) eine Wechselfolge von Mustern (2a, 6a, 10a) aus Molybdän und aus Siliziumoxid bilden.

## Claims

1. A method for producing a structure, on a substrate (1), comprising at least one mobile element (5) presenting a free area secured to the substrate (1) by a securing area, the mobile structure being formed by at least one active layer (3), the method successively comprising deposition and patterning of a first sacrificial material (2) to form a first pattern (2a) of first sacrificial material (2), deposition of the active layer (3) and patterning of the latter to allow access to the first sacrificial material (2), removal of the first sacrificial material (2) releasing the free area of the active layer (3), deposition of a second sacrificial material (6) before deposition of the first sacrificial material (2) and removal of the second sacrificial material (6) after removal of the first sacrificial material (2), method **characterized in that** it comprises formation of a second pattern (6a) in the second sacrificial material (6) after formation of the first pattern (2a), so that the first pattern (2a) of first sacrificial material (2) being arranged on the second pattern (6a) made from a second sacrificial material (6), the first pattern (2a) leaves an area of predefined width free at the periphery of a top surface of the second pattern (6a), the active layer (3) covering at least the whole of the side walls of the first and second patterns (2a, 6a) and said area of predefined width of the second pattern (6a).

2. The method according to claim 1, **characterized in that** it comprises fabrication of at least one additional sacrificial pattern above the first pattern by deposition and patterning of at least one additional sacrificial layer above the first pattern, each additional pattern leaving an area of predefined width free on the periphery of a top surface of a pattern immediately underneath.

3. The method according to one of claims 1 and 2, **characterized in that** it comprises fabrication of an element of said structure between deposition of two consecutive sacrificial layers.

4. The method according to claim 3, **characterized in that** the element of said structure is chosen from among an electrode, a resistor, an interconnect, and an insulating element.

5. The method according to any one of claims 1 to 4, **characterized in that** the substrate (1) being covered by a protective layer (7), the protective layer (7) and the first sacrificial material (2) have the same main constituents.

6. The method according to claim 5, **characterized in that** the protective layer (7) is made from thermally-formed silicon oxide and that the first sacrificial material (2) is made from silicon oxide produced by plasma enhanced chemical vapor deposition.

7. The method according to either one of claims 5 and 6, **characterized in that** the substrate and the protective layer are sensitive to the same etching agents.

8. The method according to claim 7, **characterized in that** the protective layer and the first sacrificial material (2) are etched by a hydrofluoric acid solution, by a CHF₃ plasma or by a CHF₃O₂ plasma.

9. The method according to any one of claims 1 to 8, **characterized in that** the first sacrificial material (2) is made from SiO₂ and the second sacrificial material (6) is molybdenum.

10. The method according to any one of claims 2 to 9, **characterized in that** the first sacrificial pattern (2a) is made from silicon oxide and the additional sacrificial pattern (10a) is made from molybdenum, the first sacrificial pattern (2a) being immediately underneath the additional sacrificial pattern (10a).

11. The method according to any one of claims 2 to 10, **characterized in that** the sacrificial materials (2, 6, 10) form an alternation of patterns (2a, 6a, 10a) of molybdenum and of silicon oxide perpendicularly to the surface of the substrate (1).
